# EUROPEAN PATENT APPLICATION

(11) **EP 4 845 352 A1**
(43) Date of publication of application: **25.11.2026**
(21) Application number: 25207840.7
(22) Date of filing: 09.10.2025
(51) Int. Cl.: H10F 30/221, H10F 30/223, H10F 77/14

(54) **PHOTODIODE AND MANUFACTURING METHOD THEREOF**

(30) Priority: 22.05.2025 TW 114119179
(71) Applicant: Taiwan-Asia Semiconductor Corporation, Hsinchu City 30078 (TW)
(72) Inventor: Lin, Chun-Chieh, 30078 Hsinchu City (TW)
(74) Representative: Michalski Hüttermann & Partner mbB

(57) **Abstract**

A photodiode and a manufacturing method thereof are provided. The photodiode comprises a first conductive type semiconductor layer, an intrinsic layer, a second conductive type semiconductor layer, and an upper edge bevel. The intrinsic layer is disposed on the first conductive type semiconductor layer, and the second conductive type semiconductor layer is disposed on a central region of the intrinsic layer. The upper edge bevel is arranged around an edge of the outer region of the intrinsic layer, wherein a portion of the intrinsic layer adjacent to the upper edge bevel includes a first conductivity type heavily doped region.

## Description

### CROSS-REFERENCES TO RELATED APPLICATIONS

This application claims the benefit of priority to Taiwanese Patent Application No. 114119179 filed on May 22, 2025, which is hereby incorporated by reference in its entirety.

### BACKGROUND OF THE INVENTION

### Field of the Invention

The present invention relates to a photodiode and a manufacturing method thereof, and more particularly to a photodiode with high sensitivity linearity and a manufacturing method thereof.

### Descriptions of the Related Art

A photodiode is an electronic device that converts external light signals into electrical signals. Its core function is to absorb external light for enabling the detection of optical signals and their conversion into measurable currents. This conversion is critical for various applications, such as optical communication, optical measurement, and imaging generation.

The mechanism by which a photodiode absorbs external light involves the use of semiconductor materials (e.g., silicon substrates) within the diode to absorb light. When photons enter the photodiode and are absorbed, their energy can excite electrons from the valence band to the conduction band, generating electron-hole pairs. These photogenerated carriers are separated under the influence of the built-in electric field within the diode, producing a current.

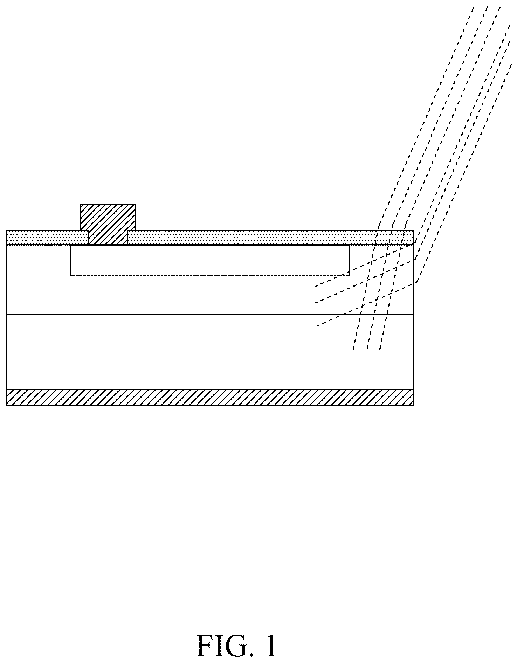

However, in practical applications, traditional photodiodes are susceptible to external light penetrating through exposed sidewalls into the device's interior, causing interference with internal operations. This adversely affects the linearity of the photosensitive device and introduces errors in calculations for the following applications. As shown in FIG. 1, external light penetrating the exposed sidewalls of a traditional photodiode is affected by the silicon substrate's refractive index of 3.4, which is greater than the air's refractive index of 1, resulting in light concentration at the device edges, thereby impacting the photodiode's sensitivity linearity.

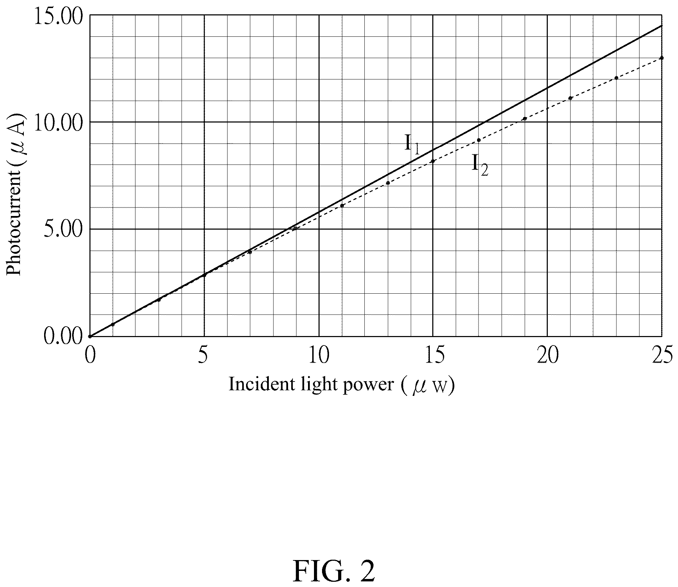

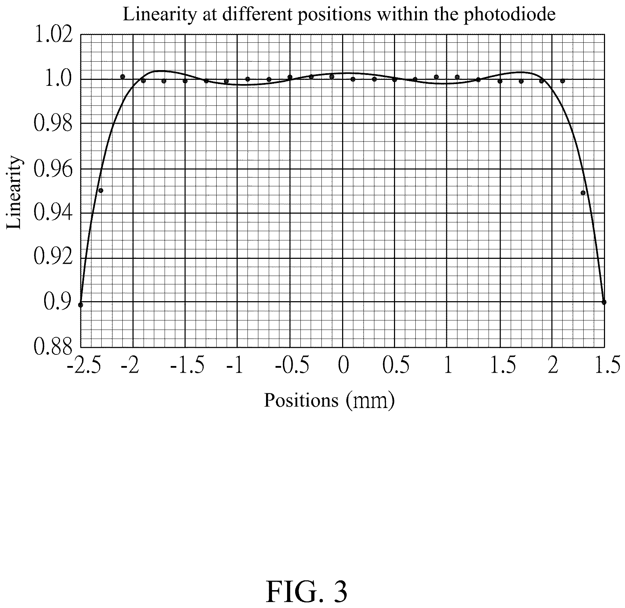

As shown in FIG. 2, line I₁ represents the ideal linearity of a photodiode, where the increase in incident light power corresponds linearly to the generated current intensity. In contrast, line I₂ represents the actual linearity of incident light power versus generated current intensity during operation. As evident, with increasing incident power, the photodiode's corresponding electrical signal intensity fails to maintain a linear relationship, exhibiting a certain degree of attenuation. Furthermore, as shown in FIG. 3, when analyzing the sensitivity linearity at different positions within the photodiode, the central region maintains high consistency in sensitivity linearity, while the edge regions experience a sharp decline. To address these issues, there is an urgent need in the industry for an innovative photodiode structure to mitigate the problem of insufficient sensitivity linearity caused by external light penetrating the sidewalls of the device.

### SUMMARY OF THE INVENTION

The primary objective of the present invention is to provide an innovative photodiode and a manufacturing method thereof. Compared to traditional photosensitive devices, the photodiode of the present invention features an upper edge bevel disposed around the upper edge of the sidewall of the device, with ion doping performed at the upper edge bevel to form an N-type heavily doped protective ring on its surface. This ring is capable to reduce the concentration of external light entering the device's interior, thereby improving the photodiode's sensitivity linearity and mitigating issues such as erroneous signals due to insufficient linearity.

To achieve the above objective, the present invention provides a photodiode comprising a first conductive type semiconductor layer, an intrinsic layer, a second conductive type semiconductor layer, and an upper edge bevel. The intrinsic layer is disposed on the first conductive type semiconductor layer, and the second conductive type semiconductor layer is disposed on a central region of the intrinsic layer. The upper edge bevel is arranged around an edge of the outer region of the intrinsic layer, wherein a portion of the intrinsic layer adjacent to the upper edge bevel includes a first conductivity type heavily doped region.

In one embodiment of the photodiode of the present invention, the upper edge bevel is one of a concave corner, a beveled corner, or a convex corner.

In one embodiment of the photodiode of the present invention, a distance between the upper edge bevel and an edge of the second conductive type semiconductor layer ranges from 30 to 60 micrometers (µm).

In one embodiment of the photodiode of the present invention, the first conductivity type heavily doped region in the intrinsic layer is an N-type heavily doped epitaxial silicon layer, with dopants selected from the group consisting of phosphorus (P), arsenic (As), antimony (Sb), and combinations thereof, and a doping concentration of 10¹⁹ to 10²² cm⁻³.

In one embodiment of the photodiode of the present invention, the photodiode further comprises an optical coating covering the second conductive type semiconductor layer and the outer region surrounding the central region of the intrinsic layer, wherein the optical coating includes a band-pass filter layer for selectively allowing light of a specific wavelength to pass through and be received by the intrinsic layer while blocking light of other wavelengths.

In one embodiment of the photodiode of the present invention, the optical coating further comprises an anti-reflective layer formed on the band-pass filter layer to enhance the transmission of the specific wavelength of light received by the intrinsic layer.

In one embodiment of the photodiode of the present invention, the intrinsic layer is an N-type lightly doped epitaxial silicon layer with phosphorus (P) as the dopant and a doping concentration of 10¹² to 10¹³ cm⁻³.

In one embodiment of the photodiode of the present invention, the second conductive type semiconductor layer is a P-type doped epitaxial silicon layer with boron (B) as the dopant and a doping concentration of 10¹⁹ to 10²⁰ cm⁻³.

To achieve the above objective, the present invention provides a manufacturing method for a photodiode, comprising the following steps: providing an intrinsic layer disposed on a first conductive type semiconductor layer; providing a second conductive type semiconductor layer disposed on a central region of the intrinsic layer; providing an upper edge bevel arranged around an edge of the outer region of the intrinsic layer; and doping a portion of the intrinsic layer adjacent to the upper edge bevel to form a first conductivity type heavily doped region.

In one embodiment of the manufacturing method for a photodiode of the present invention, the step of providing an upper edge bevel comprises a step of providing one of a concave corner, a beveled corner, or a convex corner.

In one embodiment of the manufacturing method for a photodiode of the present invention, the step of providing an upper edge bevel is a step of isotropically etching the edge of the intrinsic layer, with a distance between the upper edge bevel and an edge of the second conductive type semiconductor layer ranging from 30 to 60 micrometers (µm).

In one embodiment of the manufacturing method for a photodiode of the present invention, the step of doping a portion of the intrinsic layer adjacent to the upper edge bevel to form a first conductivity type heavily doped region comprises is a step of forming an N-type heavily doped epitaxial silicon layer, with dopants selected from the group consisting of phosphorus (P), arsenic (As), antimony (Sb), and combinations thereof, and a doping concentration of 10¹⁹ to 10²² cm⁻³.

In one embodiment of the manufacturing method for a photodiode of the present invention, the method further comprises a step of providing an optical coating covering the second conductive type semiconductor layer and the outer region surrounding the central region of the intrinsic layer, wherein the optical coating includes a band-pass filter layer for selectively allowing light of a specific wavelength to pass through and be received by the intrinsic layer while blocking light of other wavelengths.

In one embodiment of the manufacturing method for a photodiode of the present invention, the step of providing an optical coating further comprises a step of providing an anti-reflective layer formed on the band-pass filter layer to enhance the transmission of the light of the specific wavelength received by the intrinsic layer.

In one embodiment of the method for manufacturing the photodiode of the present invention, the step of providing an intrinsic layer comprises a step of providing an N-type lightly doped epitaxial silicon layer with phosphorus (P) as the dopant and a doping concentration of 10¹² to 10¹³ cm⁻³.

In one embodiment of the manufacturing method for a photodiode of the present invention, the step of providing a second conductive type semiconductor layer comprises a step of providing a P-type doped epitaxial silicon layer with boron (B) as the dopant and a doping concentration of 10¹⁹ to 10²⁰ cm⁻³.

After referring to the drawings and the embodiments as described in the following, those the ordinary skilled in this art can understand other objectives of the present invention, as well as the technical means and embodiments of the present invention.

### BRIEF DESCRIPTION OF THE DRAWINGS

FIG. 1 illustrates a schematic diagram of light concentration in a traditional photodiode structure after external light enters;
FIG. 2 illustrates a schematic diagram comparing the sensitivity linearity of a traditional photodiode under ideal and actual operating conditions;
FIG. 3 illustrates a schematic diagram of the sensitivity linearity at different positions within a traditional photodiode;
FIG. 4A illustrates a schematic diagram of a photodiode in one embodiment of the present invention;
FIG. 4B illustrates a schematic diagram of the light path of external light entering the interior of a photodiode in one embodiment of the present invention;
FIG. 5 illustrates a comparison schematic diagram of the same external light entering a photodiode of one embodiment of the present invention and a traditional photodiode;
FIG. 6 illustrates a schematic diagram of a photodiode in another embodiment of the present invention;
FIG. 7 illustrates a test comparison schematic diagram of the effect of the first conductivity type heavily doped region on the sensitivity linearity of a photodiode; and
FIG. 8 illustrates a schematic diagram of the process steps for manufacturing a photodiode in one embodiment of the present invention.

### DETAILED DESCRIPTION OF THE PREFERRED EMBODIMENT

In the following description, the present invention will be explained with reference to various embodiments thereof. These embodiments of the present invention are not intended to limit the present invention to any specific environment, application or particular method for implementations described in these embodiments. Therefore, the description of these embodiments is for illustrative purposes only and is not intended to limit the present invention. It shall be appreciated that, in the following embodiments and the attached drawings, a part of elements not directly related to the present invention may be omitted from the illustration, and dimensional proportions among individual elements and the numbers of each element in the accompanying drawings are provided only for ease of understanding but not to limit the present invention.

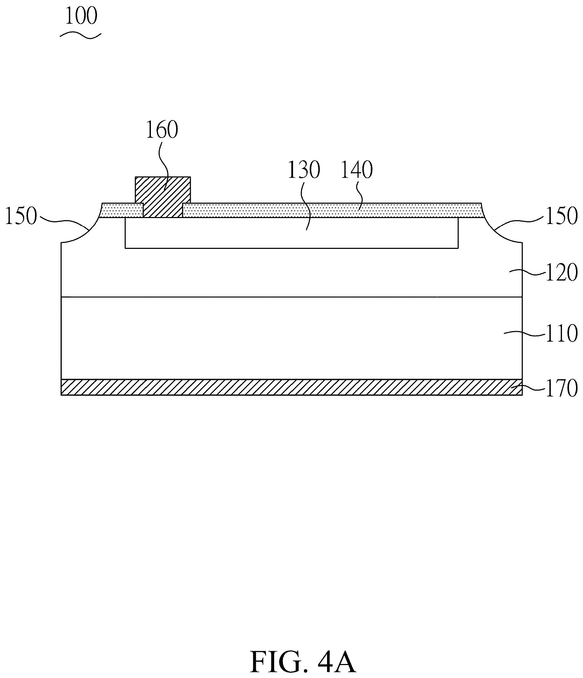

Referring to FIG. 4A, a schematic diagram illustrates a photodiode in one embodiment of the present invention. In this embodiment, the photodiode 100 comprises a first conductive type semiconductor layer 110, an intrinsic layer 120, a second conductive type semiconductor layer 130, an optical coating 140, an upper edge bevel 150, an upper electrode 160, and a lower electrode 170. The first conductive type semiconductor layer 110 may be an N-type heavily doped epitaxial silicon layer grown on a silicon wafer, for example, but not limited to, doped with antimony (Sb) during the growth of the epitaxial silicon layer, with a doping concentration of 10¹⁸ to 10¹⁹ cm⁻³. The intrinsic layer 120 is a lightly doped semiconductor layer disposed on the first conductive type semiconductor layer 110, for example, but not limited to, an N-type lightly doped epitaxial silicon layer with phosphorus (P) as the dopant and a doping concentration of 10¹² to 10¹³ cm⁻³, used to receive light of a specific wavelength and generate a corresponding electrical signal. The thickness of the intrinsic layer 120 is typically designed precisely based on the wavelength of light and application requirements, as controlling the thickness of the intrinsic layer 120 is critical to photoelectric conversion efficiency. In this embodiment, the thickness of the intrinsic layer 120 is approximately 50 to 70 micrometers (µm), but it is not limited thereto.

Additionally, as shown in FIG. 4A, the second conductive type semiconductor layer 130 is disposed on a central region of the intrinsic layer 120, exposing an outer region surrounding the central region of the intrinsic layer 120. The second conductive type semiconductor layer 130 may be a P-type doped epitaxial silicon layer, for example, but not limited to, doped with boron (B) with a doping concentration of 10¹⁹ to 10²⁰ cm⁻³. The optical coating 140 is typically a band-pass filter layer covering the second conductive type semiconductor layer 130, selectively allowing light of a specific wavelength to pass through and be received by the intrinsic layer 120 while blocking light of other wavelengths, such as visible or infrared light. The optical coating 140 is typically composed of multiple stacked dielectric materials with alternating high and low refractive indices, such as silicon dioxide (SiO₂), titanium dioxide (TiO₂), or silicon nitride (Si₃N₄). In a preferred embodiment, the optical coating 140 further includes an anti-reflective layer formed on the band-pass filter layer to enhance the transmission of the light of the specific wavelength received by the intrinsic layer, maximizing photon utilization and minimizing reflection losses of incident light, thereby improving the device's photoelectric conversion efficiency. The upper electrode 160, an anode electrode, is disposed on and electrically connected to the second conductive type semiconductor layer 130, while the lower electrode 170, a cathode electrode, is disposed on and electrically connected to the back side of the first conductive type semiconductor layer 110. The upper electrode 160 and the lower electrode 170 may be, but are not limited to, aluminum.

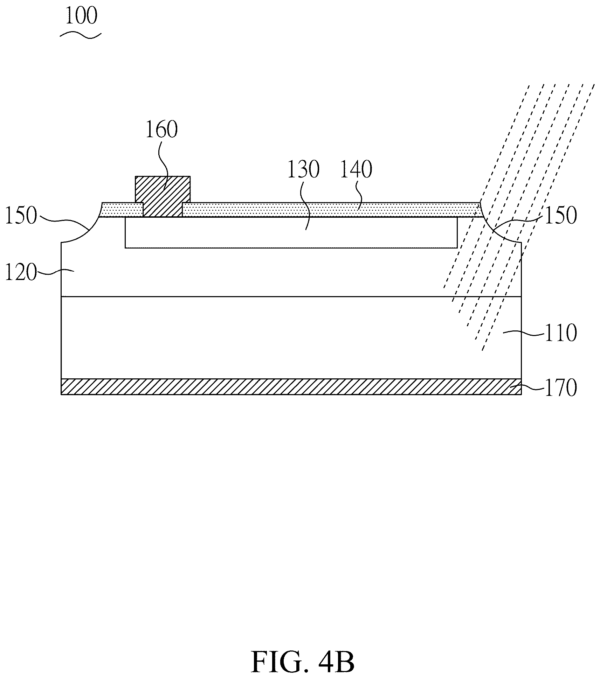

To address the issue of poor sensitivity linearity in traditional photodiodes, the photodiode 100 of the present invention specifically includes an upper edge bevel 150 disposed around the upper edge of the device structure. Referring to FIG. 4A and FIG. 4B together, the upper edge bevel 150 is arranged around an edge of the outer region of the intrinsic layer 120 and may be, for example, but not limited to, a concave corner, a beveled corner, or a convex corner. Specifically, the upper edge bevel 150 may be formed by isotropically etching the edge of the outer region of the intrinsic layer 120 to create a recessed structure, such as a beveled or concave corner, with a depth of approximately 5 to 15 micrometers (µm) from the top surface of the intrinsic layer. Preferably, the distance between the upper edge bevel 150 and an edge of the second conductive type semiconductor layer 130 ranges from 30 to 60 micrometers (µm). Based on actual test results, this spacing should not be too large or too small. If the distance between the upper edge bevel 150 and the second conductive type semiconductor layer 130 is too large, the upper edge bevel 150 does not contribute to improving the photodiode's sensitivity linearity. Conversely, if the distance is too small, it may cause leakage current.

The purpose of providing the upper edge bevel in the photodiode of the present invention is to disperse external light entering the intrinsic layer through the sidewall for reducing light concentration and thereby improving the device's sensitivity linearity. Compared to FIG. 1, FIG. 4B shows that external light entering the photodiode 100 of the present invention is significantly dispersed after being affected by the upper edge bevel 150, which alters the incident angle, causing the light path to deflect significantly toward the vertical direction. This achieves the objective of improving the photodiode's sensitivity linearity.

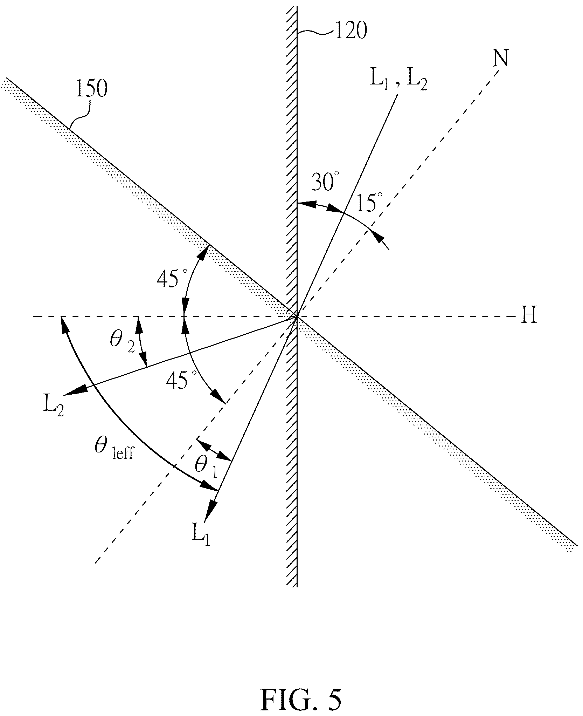

As shown in FIG. 5, the possible light paths illustrate how the upper edge bevel of the photodiode of the present invention reduces the concentration of external light. It should be noted that component number 120 in FIG. 5 represents the vertical sidewall portion of the edge of the intrinsic layer 120 in a traditional photodiode without an upper edge bevel, while component number 150 represents the beveled sidewall portion of the upper edge bevel 150 at the edge of the intrinsic layer 120 in the photodiode of the present invention. As shown in FIG. 5, when a first external light L₁ enters the beveled sidewall of the upper edge bevel 150 at an incident angle of 15° with respect to the vertical normal N (i.e., the angle between the first external light L₁ and the beveled sidewall of the upper edge bevel 150 is 75°), according to Snell's law, given the refractive index of external air as 1 and the refractive index of the silicon intrinsic layer 120 as 3.4, the refraction angle Θ₁ of the first external light L₁ inside the intrinsic layer 120 is approximately 4.4°. Consequently, the effective horizontal angle Θ_{leff} between the first external light L₁ and the horizontal line H is approximately 49.4°. In contrast, when a second external light L₂ with the same incident angle enters the vertical sidewall portion of the intrinsic layer 120 without an upper edge bevel, at an incident angle of 60° (i.e., the angle between the second external light L₂ and the vertical sidewall of the intrinsic layer 120 is 30°), the refraction angle Θ₂ inside the intrinsic layer 120 is approximately 14.8°. Comparing the two, the effective horizontal angle Θ_{1eff} (49.4°) between the first external light L₁ and the horizontal line H is greater than the refraction angle Θ₂ (14.8°) between the second external light L₂ and the horizontal line. Clearly, the photodiode with the upper edge bevel effectively deflects external light entering the device through the upper edge bevel outward, i.e., away from the central region of the device, for reducing the light concentration phenomenon seen in traditional devices and thereby improving the photodiode's sensitivity linearity.

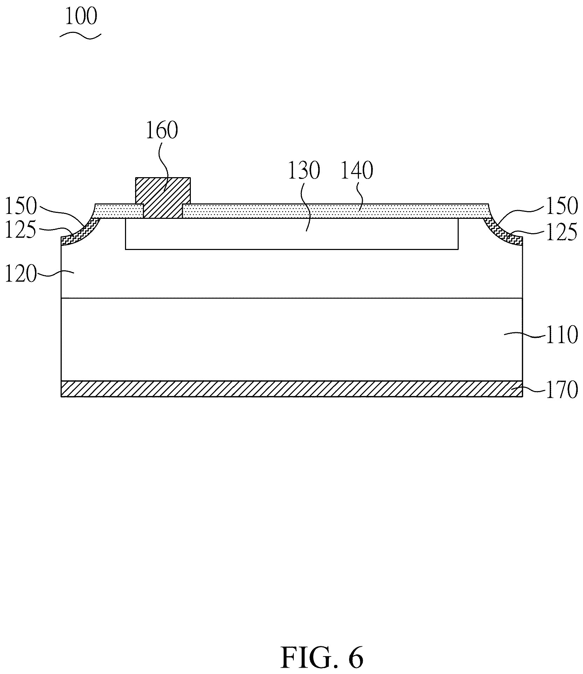

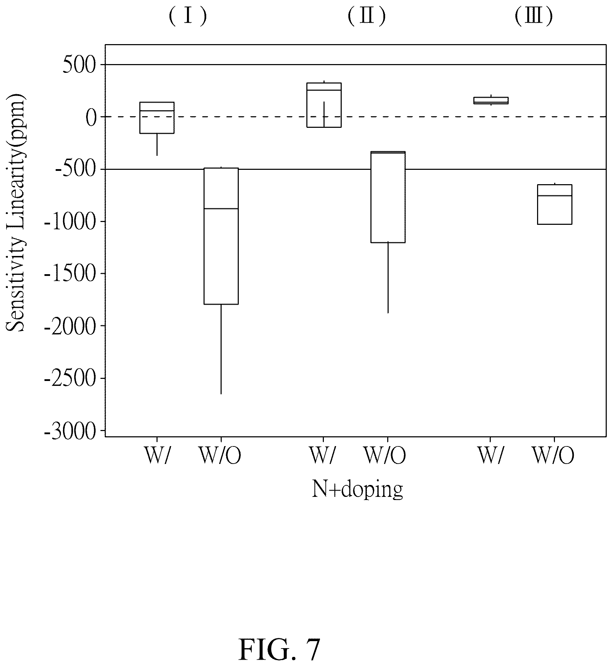

Referring to FIG. 6, another embodiment of the photodiode 100 of the present invention includes a first conductivity type heavily doped region 125 in a portion of the intrinsic layer 120 adjacent to the upper edge bevel 150, covering the surface of the upper edge bevel 150 to form a protective ring. In a preferred embodiment, the first conductivity type heavily doped region 125 is an N-type heavily doped epitaxial silicon layer with dopants selected from the group consisting of phosphorus (P), arsenic (As), antimony (Sb), and combinations thereof, and a doping concentration of 10¹⁹ to 10²² cm⁻³. The protective ring formed by the N-type heavily doped region near the upper edge bevel 150 increases electron-hole recombination at that location for reducing the generation of nonlinear photocurrent and further improving the photodiode's sensitivity linearity. Referring to FIG. 7, a test comparison schematic diagram illustrates the effect of the first conductivity type heavily doped region on the photodiode's sensitivity linearity. Specifically, three sets of experimental data (I), (II), and (III) demonstrate the effectiveness of the protective ring with the N-type heavily doped region in improving the photodiode's sensitivity linearity. The horizontal axis represents whether the upper edge bevel has N-type heavy doping (N+ doping), with "W/" indicating "positive" and "W/O" indicating "negative". The vertical axis represents the sensitivity linearity (in parts per million, ppm) of the photodiode, calculated using the following equation: $L = \left[1-\left(T4-T3\right)/\left(T2-T1\right)\right] \times {10}^{- 6}$ Equation 1 where T₁, T₂, T₃, and T₄ represent the current intensities induced under different incident light powers.

According to equation 1, under different incident light powers, if the photocurrent intensity generated by the photodiode exhibits high linearity, the difference between T3 and T4 should be proportional to the difference between T1 and T2. In other words, the four data points fall within the same linear range, making the result of (T4 - T3) / (T2 - T1) approach "1," and thus L approaches "0." A linearity test result closer to "0" indicates superior sensitivity linearity, and vice versa. Observing the three sets of experimental data (I), (II), and (III) in FIG. 7, it is clear that without N-type heavy doping at the upper edge bevel, the sensitivity linearity is approximately -500 ppm. In contrast, with N-type heavy doping at the upper edge bevel, the sensitivity linearity significantly improves, approaching "0." Evidently, providing an N-type heavily doped protective ring at the upper edge bevel has a highly significant effect on improving the photodiode's sensitivity linearity.

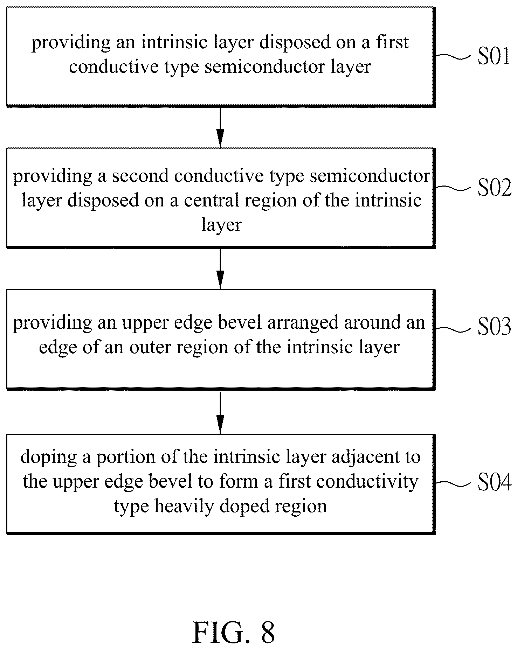

Referring to FIG. 8, a schematic flowchart illustrates the process steps for manufacturing the photodiode of the present invention. In step S01, an intrinsic layer is provided, disposed on a first conductive type semiconductor layer. In step S02, a second conductive type semiconductor layer is provided, disposed on a central region of the intrinsic layer. In step S03, an upper edge bevel is provided, arranged around an edge of the outer region of the intrinsic layer. In step S04, a portion of the intrinsic layer adjacent to the upper edge bevel is doped to form a first conductivity type heavily doped region. The descriptions of the components in the aforementioned process steps can refer to the above content and are not repeated here.

The above embodiments are provided to illustrate the implementations of the present invention and to explain its technical features, and are not intended to limit the scope of the present invention. Any modifications or equivalent arrangements that can be easily accomplished by those skilled in the art fall within the scope of the present invention, and the scope of the present invention should be defined by the claims.

## Claims

1. A photodiode, comprising:
a first conductive type semiconductor layer;
an intrinsic layer disposed on the first conductive type semiconductor layer;
a second conductive type semiconductor layer disposed on a central region of the intrinsic layer; and
an upper edge bevel arranged around an edge of an outer region of the intrinsic layer, wherein a portion of the intrinsic layer adjacent to the upper edge bevel includes a first conductivity type heavily doped region.

2. The photodiode of the previous claim, wherein the upper edge bevel is one of a concave corner, a beveled corner, or a convex corner.

3. The photodiode of any of the previous claims, wherein a distance between the upper edge bevel and an edge of the second conductive type semiconductor layer ranges from 30 to 60 micrometers (µm).

4. The photodiode of any of the previous claims, wherein the first conductivity type heavily doped region in the intrinsic layer is an N-type heavily doped epitaxial silicon layer, with dopants selected from the group consisting of phosphorus (P), arsenic (As), antimony (Sb), and combinations thereof, and a doping concentration of 10¹⁹ to 10¹² cm⁻³.

5. The photodiode of any of the previous claims, further comprising an optical coating covering the second conductive type semiconductor layer and the outer region surrounding the central region of the intrinsic layer, wherein the optical coating includes a band-pass filter layer for selectively allowing light of a specific wavelength to pass through and be received by the intrinsic layer while blocking light of other wavelengths.

6. The photodiode of the previous claim, wherein the optical coating further comprises an anti-reflective layer formed on the band-pass filter layer to enhance the transmission of the light of the specific wavelength received by the intrinsic layer.

7. The photodiode of any of the previous claim, wherein the intrinsic layer is an N-type lightly doped epitaxial silicon layer with phosphorus (P) as the dopant and a doping concentration of 10¹² to 10¹³ cm⁻³.

8. The photodiode of any of the previous claims, wherein the second conductive type semiconductor layer is a P-type doped epitaxial silicon layer with boron (B) as the dopant and a doping concentration of 10¹⁹ to 10²⁰ cm⁻³.

9. A manufacturing method for a photodiode, comprising:
providing an intrinsic layer disposed on a first conductive type semiconductor layer;
providing a second conductive type semiconductor layer disposed on a central region of the intrinsic layer;
providing an upper edge bevel arranged around an edge of an outer region of the intrinsic layer; and
doping a portion of the intrinsic layer adjacent to the upper edge bevel to form a first conductivity type heavily doped region.

10. The manufacturing method for a photodiode of the previous method claim, wherein the step of providing an upper edge bevel comprises providing one of a concave corner, a beveled corner, or a convex corner.

11. The manufacturing method for a photodiode of any of the previous method claims, wherein the step of providing an upper edge bevel is a step of isotropically etching the edge of the intrinsic layer, with a distance between the upper edge bevel and an edge of the second conductive type semiconductor layer ranging from 30 to 60 micrometers (µm).

12. The manufacturing method for a photodiode of any of the previous method claims, wherein the step of doping a portion of the intrinsic layer adjacent to the upper edge bevel to form a first conductivity type heavily doped region comprises a step of forming an N-type heavily doped epitaxial silicon layer, with dopants selected from the group consisting of phosphorus (P), arsenic (As), antimony (Sb), and combinations thereof, and a doping concentration of 10¹⁹ to 10²² cm⁻³.

13. The manufacturing method for a photodiode of any of the previous method claims, further comprising a step of providing an optical coating covering the second conductive type semiconductor layer and the outer region surrounding the central region of the intrinsic layer, wherein the optical coating includes a band-pass filter layer for selectively allowing light of a specific wavelength to pass through and be received by the intrinsic layer while blocking light of other wavelengths.

14. The manufacturing method for a photodiode of the previous claim, wherein the step of providing an optical coating further comprises a step of providing an anti-reflective layer formed on the band-pass filter layer to enhance the transmission of the specific wavelength of light received by the intrinsic layer.

15. The manufacturing method for a photodiode of any of the previous method claims, wherein the step of providing an intrinsic layer comprises a step of providing an N-type lightly doped epitaxial silicon layer with phosphorus (P) as the dopant and a doping concentration of 10¹² to 10¹³ cm⁻³, and/or wherein the step of providing a second conductive type semiconductor layer comprises a step of providing a P-type doped epitaxial silicon layer with boron (B) as the dopant and a doping concentration of 10¹⁹ to 10²⁰ cm⁻³.
